# EUROPEAN PATENT SPECIFICATION

(11) **EP 2 479 312 B1**
(45) Date of publication and mention of the grant of the patent: **25.01.2017**
(21) Application number: 10817223.0
(22) Date of filing: 15.09.2010
(51) Int. Cl.: C23C 14/34, G11B 7/26

(54) **METAL OXIDE-METAL COMPOSITE SPUTTERING TARGET**
METALLOXID-/METALL-VERBUNDSPUTTERTARGET
CIBLE DE PULVÉRISATION CATHODIQUE COMPOSITE D'OXYDE MÉTALLIQUE - MÉTAL

(30) Priority: 18.09.2009 JP 2009217750; 10.02.2010 JP 2010028094
(43) Date of publication of application: 25.07.2012
(73) Proprietor: Kobelco Research Institute, Inc., Kobe-shi, Hyogo 651-0073 (JP)
(72) Inventor: MATSUZAKI, Hitoshi, Takasago-shi Hyogo 676-8670 (JP); TAKAGI, Katsutoshi, Takasago-shi Hyogo 676-8670 (JP); JIKO, Norihiro, Takasago-shi Hyogo 676-8670 (JP); EHIRA, Masaya, Takasago-shi Hyogo 676-8670 (JP)
(74) Representative: Müller-Boré & Partner Patentanwälte PartG mbB
(86) International application number: PCT/JP2010/065988
(87) International publication number: WO 2011/034110

(56) References cited:
- JP-A- 9 279 334
- JP-A- 2005 135 568
- JP-A- 2007 169 779
- JP-A- 2008 254 245
- JP-A- 2009 102 707
- JP-A- 2009 102 707
- JP-A- 2009 228 061
- US-A1- 2001 044 018

## Description

### Technical Field

The present invention relates to a metal oxide-metal composite sputtering target useful for the formation of a recording layer for an optical information recording medium, or the like.

### Background Art

The recording layers of optical information recording media such as a Blu-ray Disc are formed of various materials such as inorganic materials and organic materials. A recording layer formed of, for example, an inorganic material is preferably formed by a sputtering method for sputtering a sputtering target of the same material as that of the recording layer. Herein, the sputtering method is the following method: in a sputtering chamber into which Ar has been introduced after evacuation, a plasma discharge is formed between a substrate and a sputtering target; the Ar ionized by the plasma discharge is caused to impinge on the sputtering target to knock out atoms of the sputtering target, and to deposit the atoms on the substrate; as a result, a thin film is formed. The thin film formed by the sputtering method is superior in in-plane uniformity of the component composition and the film thickness in the film plane direction (within the film plane), and the like to thin films formed by an ion plating method, a vacuum evaporation method, and an electron beam deposition method. Further, the sputtering method has an advantage of being capable of forming a thin film having the same component composition as that of the sputtering target as distinct from the vacuum evaporation method.

However, a metal oxide-metal composite sputtering target including a metal oxide and a metal, and useful for the formation of a recording layer for an optical information recording medium has not been heretofore specifically disclosed.

For example, Patent Document 1 discloses a write-once optical recording medium including a recording layer having a first reaction layer and a second reaction layer. In Examples, it is described to the effect that, on a substrate, a second dielectric layer formed of a mixture of ZnS and SiO₂, a second reaction layer formed of Cu, a first reaction layer formed of Si, and a first dielectric layer formed of a mixture of ZnS and SiO₂ are successively formed by a sputtering method. However, the details of the sputtering method are not described at all.

Whereas, Patent Document 2 discloses an optical information recording medium having a recording layer formed of Te, O, and a prescribed element M. In Examples, it is described to the effect that a Te-O-Pd recording layer is formed by a sputtering method. However, in the actual condition, sputtering is performed using a Te-Pd target in an atmosphere of a mixed gas of Ar and O₂. A composite sputtering target including a metal oxide and a metal is not disclosed.

Patent Document 3 discloses a sputtering target for magnetic recording films comprising cobalt metal and titanium oxide. The average grain diameter of the metal oxide phase is of the order of magnitude of 2 microns and the relative density above 92%. The metal oxide can also be aluminium oxide. The sputtering target is also suitable to be used for making an optical recording material.

### Citation List

### Patent Document

[Patent Document 1] JP-A No. 2003-203383
[Patent Document 2] JP-A No. 2002-251778
[Patent Document 3] JP-A No. 2009-102707

### Summary of Invention

### Technical Problem

The present invention was completed in view of the foregoing circumstances. It is an object thereof to provide a metal oxide-metal composite sputtering target including a metal oxide and a metal, and useful for the formation of a recording layer for an optical information recording medium, and the like.

### Solution to Problem

The present invention includes the following aspects:
(1) A metal oxide-metal composite sputtering target including a metal oxide A and a metal B, the maximum value of the circle-equivalent diameter of the metal oxide A being controlled at 200µm or less.
   Incidentally, in the metal oxide-metal composite sputtering target including a metal oxide A and a metal B of the item (1), the metal oxide A may be agglomerated.
(2) The metal oxide-metal composite sputtering target according to (1), wherein the relative density is 92% or more.
(3) The metal oxide-metal composite sputtering target according to (1) or (2), wherein a metal AM forming the metal oxide A, and the metal B are the same or different.
(4) The metal oxide-metal composite sputtering target according to any of (1) to (3), wherein the metal oxide A is at least one selected from the group consisting of In oxide, Bi oxide, Zn oxide, W oxide, Sn oxide, Co oxide, Ge oxide, and Al oxide.
(5) The metal oxide-metal composite sputtering target according to any of (1) to (4), wherein the metal B is at least one selected from the group consisting of Pd, Ag, W, Cu, Ge, Co, and Al.
(6) The metal oxide-metal composite sputtering target according to any of (1) to (5), to be used for the formation of a recording layer for an optical information recording medium.

### Advantageous Effects of Invention

For the metal oxide-metal composite sputtering target of the present invention, the maximum value of the circle-equivalent diameter of the metal oxide is controlled at 200 µm or less. For this reason, it is possible to manufacture a metal oxide-metal composite recording layer corresponding to the composition of the sputtering target with efficiency without causing problems such as the occurrence of abnormal discharge during sputtering, and the occurrence of cracking of the sputtering target due to a thermal stress. Further, for the metal oxide-metal composite sputtering target of the present invention, the relative density is preferably controlled at 92% or more. For this reason, the operation is stabilized and the productivity is enhanced without causing a problem such as the occurrence of gases from the sputtering target during sputtering.

### Brief Description of Drawings

FIGS. 1(a) and 1(b) are optical microphotographs showing the structure of a sputtering target of No. 1 (the present inventive example) used in Example, and FIG. 1(b) is an enlarged view of FIG. 1(a);
FIGS. 2(a) and 2(b) are optical microphotographs showing the structure of a sputtering target of No. 2 (the present inventive example) used in Example, and FIG. 2(b) is an enlarged view of FIG. 2(a); and
FIGS. 3(a) and 3(b) are optical microphotographs showing the structure of a sputtering target of No. 12 (Comparative example) used in Example, and FIG. 3(b) is an enlarged view of FIG. 3(a).

### Description of Embodiments

The present inventors conducted a study in order to provide a metal oxide-metal composite sputtering target including a metal oxide and a metal, and useful for the formation of a recording layer for an optical information recording medium, and the like (which may be hereinafter simply referred to as a composite sputtering target). In manufacturing of the composite sputtering target including a metal oxide, as distinct from the case of manufacturing a sputtering target not including a metal oxide, and formed of a metal, there is a large problem of how a metal oxide tending to be agglomerated can be controlled.

Namely, a metal oxide tends to be agglomerated, and an agglomerated oxide (oxide agglomerated phase) is inferior in sinterability to a metal. Therefore, a defect tends to be left in the inside of the oxide agglomerated phase. Thus, using a composite sputtering target including a large oxide agglomerated phase present therein, a thin film of a recording layer for an optical information recording medium or the like is tried to be formed by a sputtering method. Then, the oxide agglomerated phase is charged up, from which abnormal discharge may be caused. Further, the large oxide agglomerated phase becomes an inhibiting factor against heat conduction, so that cracking of the sputtering target becomes more likely to occur.

Further, as described above, a defect tends to be left in the inside of the oxide agglomerated phase. For this reason, it is difficult to enhance the relative density of the composite sputtering target including a metal oxide. Using a composite sputtering target with a low relative density, a recording layer for an optical information recording medium is tried to be formed by a sputtering method. As a result, a gas is generated from the sputtering target, which causes a bad effect such as operation instability.

Further, the reduction of the relative density of the composite sputtering target causes the reduction of thermal conductivity or the strength. Particularly, using such a composite sputtering target with a low relative density, a recording layer for an optical information recording medium is formed by a sputtering method. At this step, the applied power is tried to be set high for the purpose of improving the productivity and for other purposes. Then, the temperature of the sputtering target surface (sputtering surface) increases, so that the temperature difference between the front surface and the back surface causes a thermal stress. A metal oxide is a brittle material. Accordingly, the thermal stress causes the sputtering target to be susceptible to cracking. For this reason, the applied power cannot be set high, which brings about the reduction of the deposition rate, and further the reduction of the productivity of the optical information recording medium.

Thus, the present inventors conducted a study in order to provide a metal oxide-metal composite sputtering target capable of solving the problem accompanying the coarsening of the metal oxide agglomerated phase, and further preferably, the problem accompanying the reduction of the relative density of the composite sputtering target. As a result, the present inventors found out the following: it is very important to pay attention to particularly the mixing step in the basic steps of sputtering target manufacturing of from mixing through sintering to machining of the raw material powder. Specifically, the present inventors found out the following. There is adopted the following method: the type of a mixer and the mixing method are appropriately controlled so that the raw material powders (metal oxide A and metal B) can be uniformly mixed, and so that a large agglomerated phase is not present even when the metal oxide A is agglomerated; and if required, sieving is performed before mixing to appropriately adjust the particle size distribution of the raw material powders. As a result, it is possible to obtain a metal oxide-metal composite sputtering in which the maximum value of the circle-equivalent diameter of the metal oxide A is 200 pm or less, and preferably the relative density is controlled to be 92% or more. Thus, the present invention was completed.

First, the sputtering target of the present invention will be described.

As described above, the sputtering target of the present invention is a composite sputtering target including a metal oxide A and a metal B, and is characterized in that the maximum value of the circle-equivalent diameter of the metal oxide A is controlled at 200 µm or less. As a result, it is possible to prevent the foregoing problems, namely, abnormal discharge during sputtering, the occurrence of cracking due to a thermal stress, and the like. In order to effectively prevent the problems, the maximum value of the circle-equivalent diameter of the metal oxide A is desirably smaller, and is preferably 180 µm or less, and more preferably 100 µm or less.

Herein, the wording "the maximum value of the circle-equivalent diameter of the metal oxide A is controlled at 200 µm or less" means the following: the metal oxide A may be agglomerated (naturally, may not be agglomerated); however, even when the metal oxide A is agglomerated to form an agglomerated phase, the circle-equivalent diameter of the metal oxide A satisfies 200 µm or less at maximum. Particularly, when the circle-equivalent diameter of the metal oxide A in the observation visual field is measured in the following procedure, in any observation visual field, the maximum diameter is required to satisfy 200 µm or less. In the present invention, the reason why not the average value but the "maximum value" (maximum diameter) of the circle-equivalent diameter of the metal oxide A is specified is as follows: even when the circle-equivalent diameter of the metal oxide A is controlled small on an average, a presence of even one large metal oxide A with a maximum diameter of more than 200 µm in the observation visual field causes the foregoing defective conditions. This was proved by basic experiments by the present inventors.

### (Measuring method of the circle-equivalent diameter of metal oxide A)

First, a sputtering surface to be a measuring object is prepared. Herein, a sputtering target is cut at a plane in parallel with the sputtering surface so as to facilitate the measurement of the circle-equivalent diameter of the metal oxide A. As a result, the sputtering surface to be the measuring object is exposed. For the measuring object, the cutting plane in the vicinity of the sputtering target surface, preferably at the target outermost surface is set as the measuring object.

Then, the sample cut in the foregoing manner is embedded in a resin such as epoxy type resin, and the observing plane is mirror polished. Herein, etching of the sputtering surface is unnecessary.

Then, the circle-equivalent diameter of the metal oxide A included in the plane of the sputtering surface after mirror polishing is microscopically observed. The microscopic observation is performed using an optical microscope or a Scanning Electron Microscope: SEM. The discrimination between the metal oxide A and the metal B included in the plane of the sputtering surface is possible by any microscopic observation described above. However, it is preferable to perform SEM observation whereby the contrast is remarkable, and discrimination is easy to perform.

As the selected sites of the sputtering surface, a plurality of sites can be selected arbitrarily. However, selection of as many sites as possible enables the determination of a more precise maximum value of the circle-equivalent diameter of the metal oxide. In the present invention, preferably, for example, about 5 to 9 sites are selected per 30000-mm² sputtering surface.

Then, a microphotograph is taken for each of a plurality of selected sites. The magnification for the microscopic observation may be appropriately and properly set according to the circle-equivalent diameter of the metal oxide A, and is generally set at about 100 to 200 times. For example, when the presence or absence of the one in which the circle-equivalent diameter of the metal oxide A is more than 200 µm is judged, preferably, the magnification is set at about 100 times, and the visual field area is set large. Then number of microphotographs taken may be appropriately and properly controlled according to the magnification. For example, when the magnification is set at about 100 times, three or more visual fields are preferably set at random. On the other hand, when the magnification is set at about 200 times, the number of visual fields is preferably further increased. However, when a large agglomerated phase of the metal oxide A is not apparently observed during observation, even setting of the magnification at about 100 times is enough, and it does not matter if three or more visual fields are set at random.

Then, the circle-equivalent diameter of the metal oxide A is measured by image analysis. The image analysis is performed using an image analysis device NanoHunter NS2K-Pro manufactured by Nanosystem Corporation. The image analysis device includes a program for automatically calculating all the circle-equivalent diameters, and hence these are automatically determined. When the circle-equivalent diameters of the metal oxide A obtained in this manner are measured, those having a maximum value of 200 µm or less in any visual field are referred to as the present inventive examples.

Further, the sputtering target of the present invention preferably has a relative density of 92% or more. This can solve the problems such as operation instability due to the gas generation and the occurrence of cracking due to a thermal stress during sputtering. In order to solve these problems with reliability, the relative density is desirably set as high as possible, and is more preferably set at, for example, 95% or more. In the present invention, the relative density is the value measured by a general Archimedes method.

The sputtering targets of the present invention are composite sputtering targets each including a metal oxide A and a metal B, and includes all those in which the maximum value of the circle-equivalent diameter of the metal oxide A and, preferably, the relative density are controlled as described above irrespective of the compositions thereof. However, the composition is preferably set mainly in view of the following (I) and(II), and the like.
(I) The sputtering target of the present invention is preferably used for the formation of a recording layer for an optical information recording medium. The composition of the sputtering target is also desirably controlled so as to satisfy the main characteristics required of the recording layer. Specifically, preferably, from the viewpoint of providing a sputtering target useful for the formation of a recording layer for an optical information recording medium satisfying the required characteristics such as having a reflectance enough for reading of recording signals, being capable of recording with a practical recording laser power (having a high recording sensitivity), having a signal amplitude enough for reading of recording signals (having a high modulation degree), and having a high signal intensity (having a high C/N ratio), the composition of the sputtering target is properly controlled.
(II) Although described in details later, preferably, the combination of the metal oxide A and the metal B is properly controlled according to the relationship with the manufacturing method of the sputtering target recommended in the present invention. For example, in the present invention, there is preferably used a wet mixing method in which the metal oxide A and the metal B of raw material powders are mixed in the presence of a solvent such as water. Further, a metal with a low melting point of roughly 500°C or less as In or Bi is molten during manufacturing of the sputtering target (during sintering). For this reason, preferably, a low-melting-point metal such as In or Bi is not used as the metal B, and is used in the form of an oxide as the metal oxide A. Whereas, a metal which is instable in the form of a metal oxide as with Pd (PdO₂ decomposes at a temperature of about 700 °C) is preferably used only as the metal B. Incidentally, some metals may be used as the metal oxide A, or may be used as the metal B as with, for example, W and Co. As shown in examples described later, in the present invention, W and Co are used in either form.

Mainly in consideration of the foregoing (I) and(II), preferable metal oxides A and metals B forming the sputtering targets of the present invention are as follows.

First, the metal oxide A is preferably at least one selected from the group consisting of In oxide, Bi oxide, Zn oxide, W oxide, Sn oxide, Co oxide, Ge oxide, and Al oxide. These may be included alone, or may be used in combination of two or more thereof.

On the other hand, the metal B is preferably at least one selected from the group consisting of Pd, Ag, W, Cu, Ge, Co, and Al. These may be included alone, or may be used in combination of two or more thereof.

In the present invention, as preferable combination examples of the metal oxide A and the metal B, mention may be made of, for example, (a)Zn oxide + W + Pd, and (b) In oxide + Pd.

Then, a description will be given to a method for manufacturing a sputtering target of the present invention. In order to manufacture a sputtering target satisfying the maximum value of the circle-equivalent diameter of the metal oxide A, and further preferably the relative density, particularly, it is very important to properly control the mixing step of the raw material powders (the metal oxide A and the metal B). Specifically, as described below, it is preferable that a suitable type mixing method is selected according to the type of the mixer.

### (Mixing step)

### (1) Regarding mixer

### (1a) Use of mixer having a shearing action

As the mixer for use in the mixing step, a mixer having a shearing action of raw material powders as with a V type mixer equipped with stirring blades, a horizontal cylinder type mixer equipped with internally disposed blades, or the like is preferably used for mixing. This is for the following reason. Even when the metal oxide A is agglomerated, the agglomerated portion (agglomerated phase) is disintegrated by the stirring blades set in the mixer, the internally disposed blades, or the like. This inhibits the agglomeration of the raw material powders.

The method for performing mixing using the mixer (such as the mixing time or the number of stirrings) has no particular restriction. The method may be appropriately and properly set according to the types and amounts of the raw material powders, the type of the mixer, and the like so that the maximum value of the circle-equivalent diameter of the metal oxide A does not exceed 200 µm. However, preferably, roughly, the mixing time is controlled within the range of 60 to 90 minutes; and the numbers of stirrings are controlled within the range of 30 to 70 rpm for the barrel, and 100 to 500 rpm in the opposite direction to that of the barrel for the internally disposed blades.

### (1b) Use of mixer not having a shearing action

Alternatively, in the present invention, it is also possible to use general mixers not having a shearing action [such as a V type mixer (V mixer) and a horizontal cylinder type mixer]. In this case, as described in (2) later, for the metal oxide A, the particle size distribution of the raw material powder (metal oxide A) is preferably properly controlled before mixing. As a result, it is possible to obtain a sputtering target in which the maximum value of the circle-equivalent diameter of the metal oxide A is properly controlled (see Examples described later).

### (1c) Use of mill

Alternatively, in the present invention, a mill such as a ball mill or a vibrating mill can also be used as a mixer. The mill is generally used for crushing the raw material powders. However, in the present invention, the mill can be used for the double purpose of disintegration and mixing of the raw material powders. When mixing is performed using a mill, the mixing is preferably performed in a wet state. This can suppress the maximum value of the circle-equivalent diameter of the metal oxide A low within a prescribed range (see Examples described later). Herein, "in a wet state" means that mixing is performed in the presence of a solvent such as water. The mixing conditions have no particular restriction, and may be appropriately and properly set according to the types and amounts of the raw material powders, the type of the mill, and the like so that the maximum value of the circle-equivalent diameter of the metal oxide A does not exceed 200 µm. Specifically, for example, the raw material powders, alumina balls, and water are charged into the ball mill, and are mixed for a prescribed time. Then, the mixture is extracted and dried, and is preferably ground in a mortar, or is subjected to other treatments to undergo coarse grinding. Then, the mixture is sieved through a 36-mesh sieve, and then, is subjected to a sintering step.

### (2) Adjustment of particle size distribution before mixing for metal oxide A

Particularly for the metal oxide A, preferably, for the purpose of removing coarse powders before mixing, and properly controlling the particle size distribution, the powders are sieved through a sieve with a prescribed size, and only those which have passed through the sieve are mixed. Specifically, for the metal oxide A, for example, a 100-mesh (= size of an opening of the sieve 150 µm) is used to control the average value of the circle-equivalent diameter of the metal oxide A at roughly 150 µm or less.

Incidentally, for the metal B, it is not necessary to adjust the particle size distribution before mixing.

The (2) is not necessarily an essential step, and is preferably performed in an appropriate combination according to the type of the mixer. For example, when mixing is performed using a mixer having a shearing action as in the (1a), the (2) may be performed or may not be performed. In any case, it is confirmed in examples described later that a sputtering target having the maximum value of the circle-equivalent diameter of the metal oxide A is obtained. On the other hand, when mixing is performed using a general mixer as in the (1c), it is preferable that the (2) is performed as described above.

Incidentally, the mixing ratio of the metal oxide A and the metal B may be appropriately and properly controlled according to the composition of the recording layer for a desirable optical information recording medium.

Up to this point, a description was given to the most important mixing step of the steps for manufacturing the sputtering target in accordance with the present invention.

It is important for the sputtering target of the present invention to be manufactured with attention paid to the mixing step. For other steps than this, there can be appropriately adopted methods commonly used for manufacturing of the sputtering target. Below, for respective steps of sintering after the mixing step to machining step, preferable manufacturing steps will be described.

### (Sintering step)

The mixed powder obtained in the foregoing manner is sintered. As the sintering methods, mention may be made of HIP (Hot Isostatic Pressing), hot press, and the like. However, discharge plasma sintering described in examples later is preferably performed. The discharge plasma sintering method is a method in which the mixed powders are applied with a DC pulse current while being pressed, and a discharge plasma is generated among the powders for performing sintering. The method has advantages of being capable of performing sintering for a short time (about several minutes), and being easy to handle, and other advantages. The specific conditions for the discharge plasma sintering method vary according to the types and amounts of the raw material powders, and the like. Therefore, the heating temperature is determined by a preparatory experiment. Further, in order to increase the density, a higher pressure is more preferable. The pressure is preferably controlled within the range of roughly 40 to 50 MPa.

### (Machining step)

The sintered body obtained in the foregoing manner is machined, thereby to manufacture a sputtering target. As the machining method, mention may be made of machining using a lathe, a milling machine, or the like. However, machining using an NC lathe described in examples described later is preferable.

The thin film formed by a sputtering method using the sputtering target obtained in this manner is preferably used for, particularly, the recording layer of an optical information recording medium.

### [Examples]

Below, the present invention will be described more specifically by way of examples. However, the present invention is not limited to the following examples, and can also be carried out by adding appropriate modifications within the scope adjustable to the gist of the present invention. All of these are included within the technical scope of the present invention.

### (Example 1)

The metal oxide A-metal B-containing composite sputtering targets (Nos. 1 to 14) having various compositions shown in Table 1 were manufactured by performing mixing by the methods described in Table 1, followed by sintering and machining.

The detailed manufacturing methods of Nos. 1 to 14 are as follows.

### (Regarding No. 1)

As the raw material powders, there were prepared an In oxide powder(In oxide produced by Kisan Kinzoku Chemicals Co., Ltd., purity 99.9%, average particle size 7.3 µm, standard deviation SD 1.0 µm) and a Pd powder (produced by ISHIFUKU Metal Industry Co., Ltd., average particle size 2.0 µm, standard deviation SD 0.5 µm).

In the In oxide powder out of these, coarse ones were previously removed by using a 100-mesh sieve before mixing, and only those which had passed through the sieve were used.

Then, the raw material powders were charged into a vibrating mill, and were mixed in a wet state. Particularly, in a vibrating mill, 10-mm diameter alumina balls, 400 g of the raw material powders (228 g of the In oxide powder and 172 g of the Pd powder), and 800 mL of water were added, and then, were mixed under the conditions shown in Table 1. Subsequently, the mixture was dried at 140 °C for 2 hours, and then was crushed in a mortar. Those which had passed through the 36-mesh sieve were used for the subsequent sintering step.

The sintering process was carried out by using a discharge plasma sintering machine (SPS-3.20 MK-IV manufactured by Sumitomo Heavy Industries, Ltd.). Particularly, the mixed powder was filled in a 105-mm diameter mold made of graphite. It was set in the sintering machine, and was sintered at a heating temperature of 1000 °C, and at a pressure of 50 MPa for 1 hour. Then, by an NC lathe, machining was performed. As a result, a sputtering target of No. 1 was manufactured.

### (Regarding No. 2)

A sputtering target of No. 2 was manufactured in the same manner as with No. 1, except that, in No. 1, a Zn oxide powder (Zn oxide produced by THE HONJO CHEMICAL CORPORATION: purity 99.7%, average particle size 4.5 µm, and standard deviation SD 1.1 µm) was used in place of the In oxide powder as the raw material powder, and the mixing amounts of the Zn oxide powder and the Pd powder were set at 244 g for the Zn oxide powder, and 156 g for the Pd powder.

### (Regarding No. 3)

As the raw material powder, other than the In oxide powder and the Pd powder used for No. 1, there was further prepared an Ag powder (produced by Tokuriki Chemical Research Co., Ltd., purity 99.9%, average particle size 10 µm, and standard deviation SD 1.0 µm). Out of these, in the In oxide powder, coarse particles were previously removed by using a 100-mesh sieve, and only those which had passed through the sieve were used.

Then, the raw material powders were charged into a mixer equipped with stirring blades (manufactured by our own company KOBELCO Research Institute, Inc.), and were mixed. Particularly, 450 g of the raw material powders (247.5 g of the In oxide powder, 157.5 g of the Pd powder, and 45 g of the Ag powder) were added into the mixer, and then, were mixed under the conditions shown in Table 1, and were used in the subsequent sintering step.

For the sintering method, a discharge plasma sintering machine was used as with No. 1. Thus, sintering was carried out at a heating temperature of 940 °C, and at a pressure of 50 MPa for 1 hour. Then, machining was carried out in the same manner as with No. 1. As a result, a sputtering target of No. 3 was manufactured.

### (Regarding No. 4)

As the raw material powder, other than the In oxide powder and the Pd.powder used for No. 1, there was further prepared a W powder (produced by Wako Pure Chemical Industries, Ltd., purity 99.9%, average particle size 3.5 µm, and standard deviation SD 0.8 µm). Out of these, in the In oxide powder, as with No. 1, coarse ones were previously removed by using a 100-mesh sieve, and only those which had passed through the sieve were used.

Then, the raw material powders were charged into a ball mill, and were mixed in a wet state. Particularly, 10-mm diameter alumina balls and 500 g of the raw material powders (325 g of the In oxide powder, 150 g of the Pd powder, and 25 g of the W powder), and 700 mL of water were added into the ball mill, and then, were mixed under the conditions shown in Table 1. Subsequently, the mixture was dried at 140 °C for 2 hours, and then was crushed in a mortar. Those which had passed through the 36-mesh sieve were used for the subsequent sintering step.

For the sintering method, a discharge plasma sintering machine was used as with No. 1. Thus, sintering was carried out at a heating temperature of 1000 °C, and at a pressure of 50 MPa for 1 hour. Then, machining was carried out in the same manner as with No. 1. As a result, a sputtering target of No. 4 was manufactured.

### (Regarding No. 5)

As the raw material powders, there were prepared a Zn oxide powder (the same as in No. 2), a W oxide powder (W oxide produced by Wako Pure Chemical Industries, Ltd., purity 99.9%, average particle size 6.5 µm, and standard deviation SD 1.4 µm), and the Pd powder used for No. 1.

Then, the raw material powders were charged into a ball mill, and were mixed in a wet state. Particularly, 10-mm diameter alumina balls and 500 g of the raw material powders (275 g of the Zn oxide powder, 25 g of the W oxide powder, and 200 g of the Pd powder), and 700 mL of water were added into the ball mill, and then, were mixed under the conditions shown in Table 1. Subsequently, the mixture was dried at 140 °C for 2 hours, and then was crushed in a mortar. Those which had passed through the 36-mesh sieve were used for the subsequent sintering step.

For the sintering method, a discharge plasma sintering machine was used as with No. 1. Thus, sintering was carried out at a heating temperature of 950 °C, and at a pressure of 50 MPa for 1 hour. Then, machining was carried out in the same manner as with No. 1. As a result, a sputtering target of No. 5 was manufactured.

### (Regarding No. 6)

As the raw material powders, there were prepared the In oxide powder and the Pd powder used for No. 1.

Then, the raw material powders were charged into the mixer equipped with stirring blades used for No. 3, and were mixed in the same manner as with No. 3, and were used in the subsequent sintering step.

For the sintering method, a discharge plasma sintering machine was used as with No. 1. Thus, sintering was carried out at a heating temperature of 1000 °C, and at a pressure of 50 MPa for 1 hour. Then, machining was carried out in the same manner as with No. 1. As a result, a sputtering target of No. 6 was manufactured.

### (Regarding No. 7)

As the raw material powders, there were prepared a Bi oxide powder (Bi oxide produced by Mitsuwa Chemicals Co., Ltd., purity 99.99%, average particle size 7.5 µm, standard deviation SD 1.1 µm), a Co powder (produced by UMICORE, purity 99.9%, average particle size 10 µm, standard deviation SD 2.0 µm), and a Ge powder (produced by Wako Pure Chemical Industries, Ltd., purity 99.99%, average particle size 11 µm, and standard deviation SD 2.4 µm).

Then, the raw material powders were charged into a vibrating mill, and were mixed in a wet state. Particularly, 10-mm diameter alumina balls, 400g of the raw material powders (228 g of the Bi oxide powder, 132 g of the Co powder, and 40 g of the Ge powder), and 700 mL of water were added into the vibrating mill, and then, were mixed under the conditions shown in Table 1. Subsequently, the mixture was dried at 140 °C for 2 hours, and then was crushed using a mortar. Those which had passed through a 36-mesh sieve were used for the subsequent sintering step.

For the sintering method, a discharge plasma sintering machine was used as with No. 1. Thus, sintering was carried out at a heating temperature of 1000 °C, and at a pressure of 50 MPa for 1 hour. Then, machining was carried out in the same manner as with No. 1. As a result, a sputtering target of No. 7 was manufactured.

### (Regarding No. 8)

As the raw material powders, there were prepared a Sn oxide powder (Sn oxide produced by Mitsuwa Chemicals Co., Ltd., purity 99.9%, average particle size 5.0 µm, and standard deviation SD 1.1 µm), and the Pd powder and the Ag powder used for No. 3. Out of these, in the Sn oxide powder, coarse ones were previously removed by using a 100-mesh sieve, and only those which had passed through the sieve were used.

Then, the raw material powders were charged into a ball mill, and were mixed in a wet state. Particularly, 10-mm diameter alumina balls, 450 g of the raw material powders (265 g of the Sn oxide powder, 135 g of the Pd powder, and 22.5 g of the Ag powder), and 700mL of water were added into a ball mill, and then, were mixed under the conditions shown in Table 1. Subsequently, the mixture was dried at 140 °C for 2 hours, and then was crushed using a mortar. Those which had passed through a 36-mesh sieve were used for the subsequent sintering step.

For the sintering method, a discharge plasma sintering machine was used as with No. 1. Thus, sintering was carried out at a heating temperature of 1000 °C, and at a pressure of 40 MPa for 1 hour. Then, machining was carried out in the same manner as with No. 1. As a result, a sputtering target of No. 8 was manufactured.

### (Regarding No. 9)

As the raw material powders, there were prepared the Zn oxide powder used for No. 5, a Co oxide powder (Co oxide produced by Mitsuwa Chemicals Co., Ltd., purity 99.9%, average particle size 6.3 µm, and standard deviation SD 1.3 µm), the Pd powder used for No. 1, and a Cu powder (produced by Yamaishi Metal Co., Ltd., purity 99.9%, average particle size 12 µm, and standard deviation SD 2.3 µm).

Then, the raw material powders were charged into the mixer equipped with stirring blades used for No. 3, and were mixed. Particularly, into the mixer, 400 g of the raw material powders (160 g of a Zn oxide powder, 20 g of a Co oxide powder, 160 g of a Pd powder, and 60 g of a Cu powder) were added, and then were mixed under the conditions shown in Table 1. The resulting mixture was used for the subsequent sintering step.

For the sintering method, a discharge plasma sintering machine was used as with No. 1. Thus, sintering was carried out at a heating temperature of 900 °C, and at a pressure of 50 MPa for 1 hour. Then, machining was carried out in the same manner as with No. 1. As a result, a sputtering target of No. 9 was manufactured.

### (Regarding No. 10)

As the raw material powders, the Bi oxide powder used for No. 7, a Ge oxide powder (Ge oxide produced by Kisan Kinzoku Chemicals Co., Ltd., purity 99.99%, average particle size 7 µm, and standard deviation SD 1.0 µm), and the Pd powder used for No. 1. Out of these, in the Bi oxide powder and the Ge oxide powder, coarse ones were previously removed by using a 100-mesh sieve, and only those which had passed through the sieve were used.

Then, the raw material powders were charged into a V mixer, and were mixed. Particularly, into the V mixer, 400 g of the raw material powders (188 g of a Bi oxide powder, 80 g of a Ge oxide powder, and 132 g of a Pd powder) were added, and then, were mixed under the conditions shown in Table 1. Subsequently, the mixture was dried at 140 °C for 2 hours, and then was crushed using a mortar. Those which had passed through the 100-mesh sieve were used for the subsequent sintering step.

For the sintering method, a discharge plasma sintering machine was used as with No. 1. Thus, sintering was carried out at a heating temperature of 1000 °C, and at a pressure of 50 MPa for 1 hour. Then, machining was carried out in the same manner as with No. 1. As a result, a sputtering target of No. 10 was manufactured.

### (Regarding No. 11)

As the raw material powders, there were prepared the Zn oxide powder used for No. 2, the Pd powder used for No. 1, and the Cu powder used for No. 9.

Then, the raw material powders were charged into a V mixer, and were mixed. Particularly, into the V mixer, 400 g of the raw material powders (204 g of a Zn oxide powder, 156 g of a Pd powder, and 40 g of a Cu powder) were added, and then, were mixed under the conditions shown in Table 1. The resulting mixture was used for the subsequent sintering step.

For the sintering method, a discharge plasma sintering machine was used as with No. 1. Thus, sintering was carried out at a heating temperature of 950 °C, and at a pressure of 50 MPa for 1 hour. Then, machining was carried out in the same manner as with No. 1. As a result, a sputtering target of No. 11 was manufactured.

### (Regarding No. 12)

As the raw material powders, there were prepared the In oxide powder used for No. 1 and the Pd powder used for No. 1.

Then, the raw material powders were charged into a V mixer, and were mixed. Particularly, into the V mixer, 400 g of the raw material powders (228 g of an In oxide powder and 172 g of a Pd powder) were added, and then, were mixed under the conditions shown in Table 1. The resulting mixture was used for the subsequent sintering step.

For the sintering method, a discharge plasma sintering machine was used as with No. 1. Thus, sintering was carried out at a heating temperature of 1000°C, and at a pressure of 50 MPa for 1 hour. Then, machining was carried out in the same manner as with No. 1. As a result, a sputtering target of No. 12 was manufactured.

### (Regarding No. 13)

As the raw material powders, there are prepared the Zn oxide powder used for No. 2, and the Pd powder used for No. 1.

Then, the raw material powders were charged into a V mixer, and were mixed. Particularly, into the V mixer, 400 g of the raw material powders (244 g of a Zn oxide powder and 156 g of a Pd powder) were added, and then, were mixed under the conditions shown in Table 1. The resulting mixture was used for the subsequent sintering step.

For the sintering method, a discharge plasma sintering machine was used as with No. 1. Thus, sintering was carried out at a heating temperature of 950 °C, and at a pressure of 50 MPa for 1 hour. Then, machining was carried out in the same manner as with No. 1. As a result, a sputtering target of No. 13 was manufactured.

### (Regarding No. 14)

As the raw material powders, there were prepared an In oxide powder (the same as in No. 1), a Zn oxide powder (the same as in No. 2), an Al oxide powder (produced by Mitsuwa Chemicals Co., Ltd., purity 99.99%, average particle size 0.3 µm, standard deviation SD 0.1 µm), and a Pd powder (the same as in No. 1).

Then, the raw material powders were charged into a ball mill, and were mixed in a wet state. Particularly, into a ball mill, 10-mm diameter alumina balls, 500 g of the raw material powders (335 g of an In oxide powder, 65 g of a Zn oxide powder, 30 g of an Al oxide powder, and 70 g of a Pd powder), and 700 mL of water were added, and then were mixed under the conditions shown in Table 1. Subsequently, the mixture was dried at 140 °C for 2 hours, and then was crushed using a mortar. Those which had passed through a 36-mesh sieve were used for the subsequent sintering step.

For the sintering method, a discharge plasma sintering machine was used as with No. 1. Thus, sintering was carried out at a heating temperature of 950 °C, and at a pressure of 50 MPa for 1 hour. Then, machining was carried out in the same manner as with No. 1. As a result, a sputtering target of No. 14 was manufactured.

For each sputtering target of Nos. 1 to 14 thus manufactured (disc shape, diameter 101.6 mm, and thickness 5.0 mm), the maximum value of the circle-equivalent diameter of the metal oxide and the relative density were measured with the foregoing methods. In addition, the abnormal discharge and the operation stability were evaluated with the following methods.

### (Evaluation method of abnormal discharge)

The sputtering target was mounted in a sputtering device (sputtering system "HSR-542S" manufactured by SHIMADZU CORPORATION), and DC magnetron sputtering was carried out. At this step, the number of occurrences of abnormal discharge (arching) was measured by an arc monitor (the Micro Arc Monitor "MAM Genesis" measuring instrument manufactured by Landmark Technology Co., Ltd.) connected to the power source of the sputtering device. Incidentally, the conditions for DC magnetron sputtering were set as follows: Ar flow rate: 10 sccm, oxygen flow rate: 10 sccm, gas pressure: 0.4 Pa, DC sputtering power: 200 W, and substrate temperature: room temperature.

In the present example, the abnormal discharge was evaluated based on the following criteria. In the present example, no occurrence of abnormal discharge (a number of occurrences of arching of 0) was rated as abnormal discharge pass (A), and the occurrence (a number of occurrences of arching of 1 or more) was rated as abnormal discharge failure (B).

### (Evaluation method of operation stability)

Further, for mounting the sputtering target on a sputtering device (the sputtering system "HSR-542S" manufactured by SHIMADZU CORPORATION), and performing DC magnetron sputtering, the sputtering chamber is evacuated to a back pressure of 0.27 × 10⁻³ Pa. When the relative density is low, the gases present in the pores in the sputtering target are released. Accordingly, a long time is required for the evacuation. Thus, the evacuation time until the pressure reaches a prescribed back pressure was measured.

In the present example, the operation stability was evaluated based on the following criteria. In the present example, the case where the evacuation time was within 2 hours was rated as operation stability pass (A), and the case of more than 2 hours was rated as operation stability failure (B).

The results are summarized in Table 1. Incidentally, a column of overall rating is disposed at the rightmost column of Table 1. The one rated as pass (A) in terms of abnormal discharge, and also rated as pass (A) in terms of operation stability is rated as "overall rating A"; the one rated as pass (A) in terms of abnormal discharge, and rated as failure (B) in terms of operation stability is also rated as "overall rating A"; and the one rated as failure (B) in terms of abnormal discharge is rated as " overall rating B".

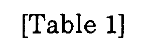

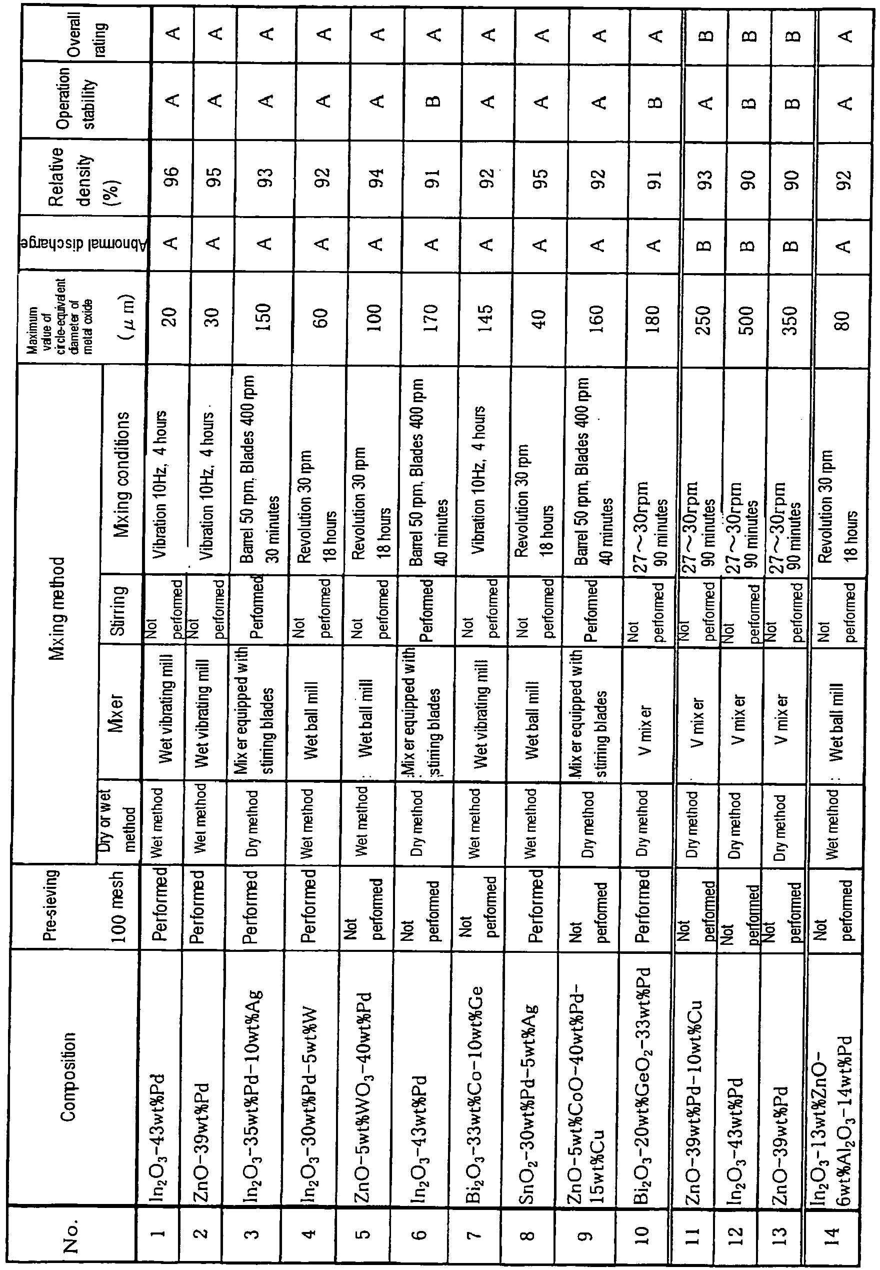

From Table 1, the following consideration can be given.

First, for Nos. 1 to 10, and 14 manufactured by preferable mixing methods of the present invention, the maximum value of the circle-equivalent diameter of the metal oxide was controlled at 200µm or less regardless of the composition of each sputtering target. For this reason, it was possible to prevent the abnormal discharge during sputtering. Out of these, those further appropriately controlled in relative density (Nos. 1 to 5, 7 to 9, and 14) were also found to be excellent in operation stability.

Particularly, Nos. 1, 2, 4, and 8 are examples subjected to wet mixing after having been sieved before mixing (pre-sieving). Both of the maximum value of the circle-equivalent diameter of the metal oxide and the relative density were appropriately controlled. Accordingly, it was possible to prevent the abnormal discharge during sputtering. In addition, the operation stability was also good.

On the other hand, Nos. 5, 7, and, 14 are examples subjected to wet mixing without having previously been subjected to sieving. As compared with the Nos. 1, 2, 4, and 8 subjected to pre-sieving, the maximum value of the circle-equivalent diameter of the metal oxide became slightly larger, but satisfied the range of the present invention. Accordingly, it was possible to prevent the abnormal discharge during sputtering. Further, the relative density was also appropriately controlled, and hence the operation stability was also good.

No. 3 is an example subjected to mixing by a mixer equipped with stirring blades after having been subjected to pre-sieving. Both of the maximum value of the circle-equivalent diameter of the metal oxide and the relative density were appropriately controlled. Accordingly, it was possible to prevent the abnormal discharge during sputtering. In addition, the operation stability was also good.

On the other hand, Nos. 6 and 9 are examples subjected to mixing by a mixer equipped with stirring blades without having previously been subjected to sieving. As compared with the No. 3 subjected to pre-sieving, the maximum value of the circle-equivalent diameter of the metal oxide became slightly larger, but satisfied the range of the present invention. Accordingly, it was possible to prevent the abnormal discharge during sputtering. Incidentally, for No. 6, the relative density of the sputtering target was reduced.

No. 10 is an example subjected to mixing by a V mixer in a dry state after having been subjected to pre-sieving. The maximum value of the circle-equivalent diameter of the metal oxide was controlled small, so that abnormal discharge did not occur.

In contrast, Nos. 11 to 13 are examples subjected to mixing by a V mixer in a dry state without having previously been subjected to sieving. The maximum value of the circle-equivalent diameter of the metal oxide became larger, so that abnormal discharge occurred during sputtering. Whereas, for Nos. 12 and 13, the content of oxides was higher than that of No.11. For this reason, the relative density of the sputtering target was reduced, and the operation stability was inferior. An oxide generally has a higher melting point than that of a metal. Therefore, at the same temperature, an oxide is more stable, and diffusion of atoms is slow. Accordingly, sintering is less likely to proceed. Further, the hardness is high. Thus, particles are not deformed at the same temperature and pressure, so that voids between particles cannot be filled. For such reasons, the one having a high oxide content is reduced in relative density.

The experimental results of No. 10, and Nos. 11 to 13 indicate as follows: it is useful to perform pre-sieving before mixing in the case of adopting a mixing method for performing mixing by a V mixer in a dry state.

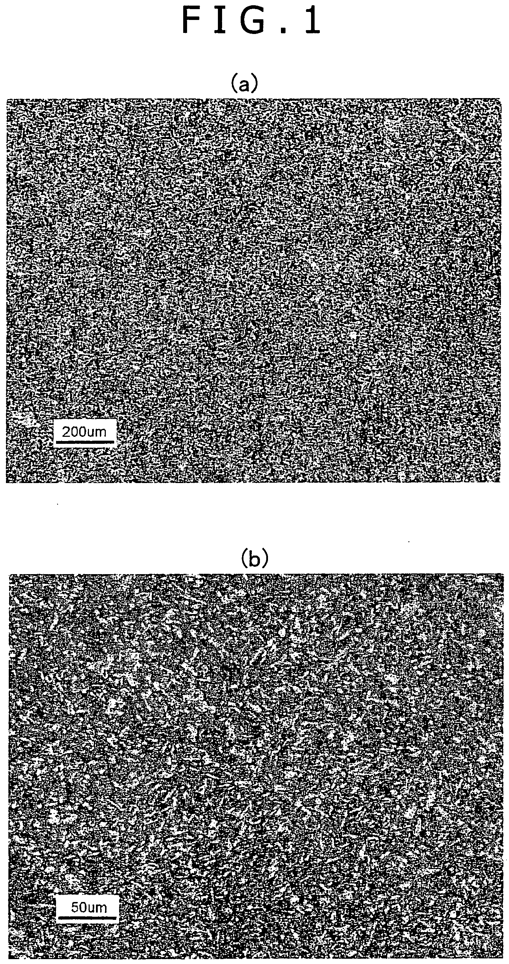

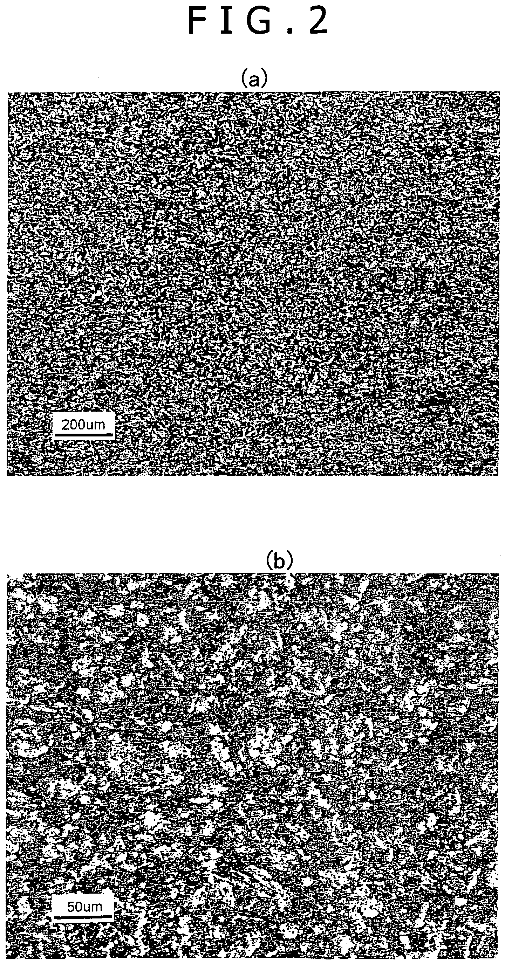

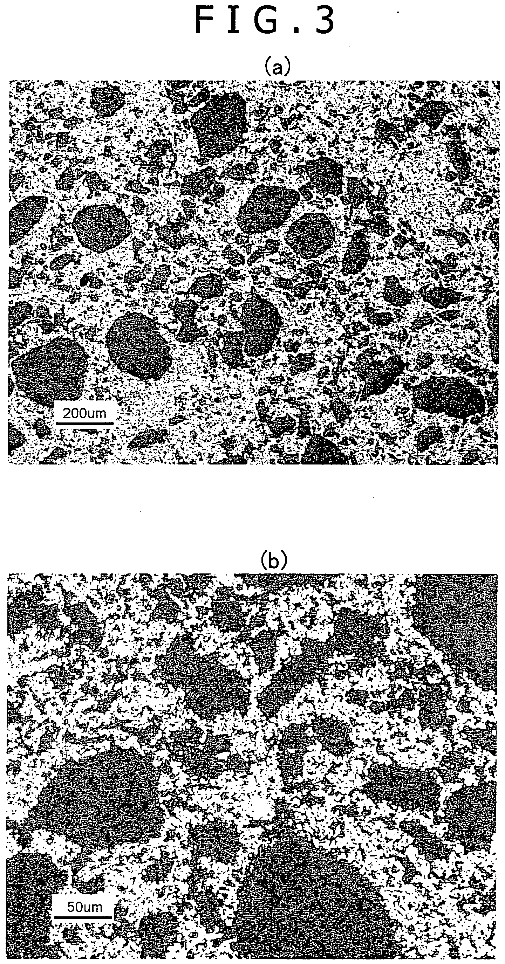

For reference purposes, the microphotographs of No. 1 and No. 2 (both are the present inventive examples), and No. 12 (Comparative Example) are shown in FIGS. 1(a) and 1(b), FIGS. 2(a) and 2(b), and FIGS. 3(a) and 3(b), respectively. As shown in the drawings, for both of No. 1 and No. 2 satisfying the requirements of the present invention, the maximum value of the circle-equivalent diameter of the metal oxide is controlled low. In contrast, for No. 12 not satisfying the requirements of the present invention, the maximum value of the circle-equivalent diameter of the metal oxide was large, and a large oxide agglomerated phase was observed.

The present application is based on Japanese Patent Application No. 2009-217750 filed on Sept. 18, 2009, and Japanese Patent Application No. 2010-028094 filed on Feb. 10, 2010,

### Industrial Applicability

For the metal oxide-metal composite sputtering target of the present invention, the maximum value of the circle-equivalent diameter of the metal oxide is controlled at 200 µm or less. For this reason, a metal oxide-metal composite recording layer corresponding to the composition of the sputtering target can be manufactured with efficiency without causing problems such as the occurrence of abnormal discharge during sputtering, and the occurrence of cracking of the sputtering target due to a thermal stress. Further, for the metal oxide-metal composite sputtering target of the present invention, preferably, the relative density is controlled at 92% or more. For this reason, the operation is stabilized, and the productivity is enhanced without causing a problem such as the occurrence of gases from the sputtering target during sputtering.

## Claims

1. A metal oxide-metal composite sputtering target comprising a metal oxide A and a metal B, the maximum value of the circle-equivalent diameter of the metal oxide A being controlled at 200 µm or less, wherein the metal oxide A may be agglomerated and is at least one selected from the group consisting of In oxide, Bi oxide, Zn oxide, W oxide, Sn oxide, Co oxide and Ge oxide.

2. The metal oxide-metal composite sputtering target according to claim 1, wherein the metal B is at least one selected from the group consisting of Pd, Ag, W, Cu, Ge, Co, and Al.

3. A metal oxide-metal composite sputtering target comprising a metal oxide A and a metal B, the maximum value of the circle-equivalent diameter of the metal oxide A being controlled at 200 µm or less, wherein the metal oxide A may be agglomerated and is Al oxide and the metal B is at least one selected from the group consisting of Pd, Ag, W, Cu, Ge, Co, and Al.

4. The metal oxide-metal composite sputtering target according to any one of claims 1 to 3, wherein the relative density is 92% or more.

5. The metal oxide-metal composite sputtering target according to any one of claims 1 to 4, wherein a metal AM forming the metal oxide A, and the metal B are the same or different.

6. The metal oxide-metal composite sputtering target according to any one of claims 1 to 5, to be used for the formation of a recording layer for an optical information recording medium.

## Patentansprüche

1. Metalloxid-Metall-Verbundsputtertarget, umfassend ein Metalloxid A und ein Metall B, mit einem auf 200 µm oder weniger eingestellten Maximalwert des Kreisäquivalentdurchmessers des Metalloxids A, wobei das Metalloxid A agglomeriert sein kann und mindestens eines, ausgewählt aus der Gruppe, bestehend aus In-Oxid, Bi-Oxid, Zn-Oxid, W-Oxid, Sn-Oxid, Co-Oxid und Ge-Oxid, ist.

2. Metalloxid-Metall-Verbundsputtertarget nach Anspruch 1, wobei das Metall B mindestens eines, ausgewählt aus der Gruppe, bestehend aus Pd, Ag, W, Cu, Ge, Co und Al, ist.

3. Metalloxid-Metall-Verbundsputtertarget, umfassend ein Metalloxid A und ein Metall B, mit einem auf 200 µm oder weniger eingestellten Maximalwert des Kreisäquivalentdurchmessers des Metalloxids A, wobei das Metalloxid A agglomeriert sein kann und Al-Oxid ist und das Metall B mindestens eines, ausgewählt aus der Gruppe, bestehend aus Pd, Ag, W, Cu, Ge, Co und Al, ist.

4. Metalloxid-Metall-Verbundsputtertarget nach einem der Ansprüche 1 bis 3, wobei die relative Dichte 92% oder mehr beträgt.

5. Metalloxid-Metall-Verbundsputtertarget nach einem der Ansprüche 1 bis 4, wobei ein Metall AM, welches das Metalloxid A bildet, und das Metall B gleich oder verschieden sind.

6. Metalloxid-Metall-Verbundsputtertarget nach einem der Ansprüche 1 bis 5, um zur Bildung einer Aufzeichnungsschicht für ein optisches Informationsaufzeichnungsmedium verwendet zu werden.

## Revendications

1. Une cible de pulvérisation composite en métal-oxyde de métal comprenant un oxyde de métal A et un métal B, la valeur maximale de diamètre de cercle équivalent de l'oxyde de métal étant contrôlée à 200µm ou moins, dans laquelle l'oxyde de métal A peut être aggloméré et est au moins un sélectionné parmi le groupe consistant en oxyde d'In, oxyde de Bi, oxyde de Zn, oxyde de W, oxyde de Sn, oxyde de Co et oxyde de Ge.

2. La cible de pulvérisation composite en métal-oxyde de métal selon la revendication 1, dans laquelle le métal B est au moins un sélectionné parmi le groupe consistant en Pd, Ag, W, Cu, Ge, Co et Al.

3. Une cible de pulvérisation composite en métal-oxyde de métal comprenant un oxyde de métal A et un métal B, la valeur maximale de diamètre de cercle équivalent de l'oxyde de métal étant contrôlée à 200µm ou moins, dans laquelle l'oxyde de métal A peut être aggloméré et est un oxyde d'Al et le métal B est au moins un sélectionné parmi le groupe consistant en Pd, Ag, W, Cu, Ge, Co et Al.

4. La cible de pulvérisation composite en métal-oxyde de métal selon l'une quelconque des revendications 1 à 3, dans laquelle la densité relative est de 92% ou plus.

5. La cible de pulvérisation composite en métal-oxyde de métal selon l'une quelconque des revendications 1 à 4, dans laquelle un métal AM formant l'oxyde de métal A, et le métal B sont différentes ou identiques.

6. La cible de pulvérisation composite en métal-oxyde de métal selon l'une quelconque des revendications 1 à 5, étant utilisée pour la formation d'une couche d'enregistrement pour un support d'enregistrement optique d'informations.
